# EUROPEAN PATENT APPLICATION

(11) **EP 4 307 350 A2**
(43) Date of publication of application: **17.01.2024**
(21) Application number: 23179094.0
(22) Date of filing: 14.06.2023
(51) Int. Cl.: H01L 21/337, H01L 21/76, H01L 29/778, H01L 29/20, H01L 29/40, H01L 29/423, H01L 29/10

(54) **COMPOUND SEMICONDUCTOR-BASED DEVICES WITH STRESS-REDUCTION FEATURES**

(30) Priority: 14.07.2022 US 202217864499
(71) Applicant: GLOBALFOUNDRIES Singapore Pte. Ltd., Singapore 738406 (SG)
(72) Inventor: SUSAI, Lawrence Selvaraj, 738406 Singapore (SG); LINEWIH, Handoko, 738406 Singapore (SG); HEBERT, Francois, San Mateo, CA, 94402 (US); MARIO, Hendro, 738406 Singapore (SG); CHWA, Siow Lee, 738406 Singapore (SG)
(74) Representative: Lambacher, Michael

(57) **Abstract**

Structures including compound semiconductor-based devices and silicon-based devices integrated on a semiconductor substrate and methods of forming such structures. The structure comprises a layer stack on a substrate, a conductive contact extending in a vertical direction fully through the layer stack to the substrate, and a device structure including a source ohmic contact and a drain ohmic contact. The layer stack including a plurality of semiconductor layers each comprising a compound semiconductor material, the conductive contact is arranged in the layer stack to separate a first portion of the layer stack from a second portion of the layer stack, and the source ohmic contact and the drain ohmic contact have a contacting relationship with at least one of the plurality of semiconductor layers of the first portion of the layer stack.

## Description

### BACKGROUND

The disclosure relates to semiconductor device fabrication and integrated circuits and, more specifically, to structures including compound semiconductor-based devices and methods of forming such structures.

Compound semiconductor-based devices, such as high-electron-mobility transistors, may be deployed in high-voltage power electronics. Compound semiconductors are characterized by material properties, such as a carrier mobility that is greater than the carrier mobility of silicon and a wider band gap than silicon, that can be exploited. Compound semiconductors may include Group III elements (e.g., aluminum, gallium, and/or indium) and Group V elements (e.g., nitrogen, phosphorus, arsenic, and/or antimony) combined with the Group III elements. A common wide-band-gap compound semiconductor employed in constructing compound semiconductor-based devices is gallium nitride. A high-electron-mobility transistor may include a heterojunction between crystalline compound semiconductor materials having different band gaps, such as a heterojunction between binary gallium nitride and trinary aluminum-gallium nitride. During operation, a two-dimensional electron gas is formed near an interface at the heterojunction and defines the channel of the high-electron-mobility transistor.

A compound semiconductor-based device may include a stack of compound semiconductor layers that are grown by heteroepitaxy on a substrate. The layers are optimized in order to manage stresses caused by, for example, differences in the coefficient of thermal expansion between the substrate and the epitaxial compound semiconductor layers on the substrate. Thermal steps during subsequent processing may result in cracking and/or breakage due to differences in the coefficient of thermal expansion and other stresses.

Improved structures including III-V compound semiconductor-based devices and methods of forming such structures are needed.

### SUMMARY

In an embodiment of the invention, a structure comprises a layer stack on a substrate, a conductive contact extending in a vertical direction fully through the layer stack to the substrate, and a device structure including a source ohmic contact and a drain ohmic contact. The layer stack including a plurality of semiconductor layers each comprising a compound semiconductor material, the conductive contact is arranged in the layer stack to separate a first portion of the layer stack from a second portion of the layer stack, and the source ohmic contact and the drain ohmic contact have a contacting relationship with at least one of the plurality of semiconductor layers of the first portion of the layer stack.

The device structure may be a high-electron-mobility transistor that includes a gate on the first portion of the layer stack.

The substrate of the structure may comprises a heavily-doped semiconductor material. The compound semiconductor material of at least one of the plurality of semiconductor layers may comprise gallium nitride.

The conductive contact may fully surround the first portion of the layer stack. Alternatively, the conductive contact may be positioned in a lateral direction between the first portion of the layer stack and the second portion of the layer stack as a partition.

The conductive contact may have an end in direct contact with the substrate. Further, the conductive contact may comprise tungsten or doped polysilicon.

Further, the conductive contact of the structure may be formed in a trench penetrating through the layer stack to the substrate. The trench may have an inner sidewall and an outer sidewall.

The structure may further comprise a first dielectric spacer between the conductive contact and the inner sidewall of the trench, and a second dielectric spacer between the conductive contact and the outer sidewall of the trench. Optionally, the conductive contact, the first dielectric spacer, and the second dielectric spacer may fully surround the first portion of the layer stack. Alternatively, the conductive contact, the first dielectric spacer, and the second dielectric spacer may be positioned in a lateral direction between the first portion of the layer stack and the second portion of the layer stack as a partition.

The structure may further comprise a dielectric layer on the layer stack. In this configuration, the conductive contact may include a first portion in the layer stack and a second portion in the dielectric layer. More specifically, the conductive contact may be formed in a trench penetrating through the dielectric layer and the layer stack to the substrate. Moreover, the first dielectric spacer may be between the conductive contact and the inner sidewall of the trench, and the second dielectric spacer may be between the conductive contact and the outer sidewall of the trench.

The structure may further comprise an isolation region in one or more of the plurality of semiconductor layers of the layer stack. In this configuration the conductive contact may also penetrate through the isolation region. Optionally, the conductive contact and the isolation region may fully surround the first portion of the layer stack. Alternatively, the conductive contact and the isolation region may be positioned in a lateral direction between the first portion of the layer stack and the second portion of the layer stack as a partition.

In an embodiment of the invention, a method comprises forming a layer stack on a substrate, forming a conductive contact extending in a vertical direction fully through the layer stack to the substrate, and forming a device structure including a source ohmic contact and a drain ohmic contact. The layer stack includes a plurality of semiconductor layers each comprising a compound semiconductor material, the conductive contact is arranged in the layer stack to separate a first portion of the layer stack from a second portion of the layer stack, and the source ohmic contact and the drain ohmic contact in a contacting relationship with at least one of the plurality of semiconductor layers of the first portion of the layer stack.

The conductive contact may be formed in a trench penetrating through the layer stack to the substrate, wherein the trench may have an inner sidewall and an outer sidewall, and the method may further comprise: forming a first dielectric spacer between the conductive contact and the inner sidewall of the trench; and forming a second dielectric spacer between the conductive contact and the outer sidewall of the trench.

The trench may be formed before the device structure is formed.

### BRIEF DESCRIPTION OF THE DRAWINGS

The accompanying drawings, which are incorporated in and constitute a part of this specification, illustrate various embodiments of the invention and, together with a general description of the invention given above and the detailed description of the embodiments given below, serve to explain the embodiments of the invention. In the drawings, like reference numerals refer to like features in the various views.
FIGS. 1-4 are cross-sectional views of a structure at successive fabrication stages in accordance with embodiments of the invention.
FIG. 5 is a cross-sectional view of a structure in accordance with alternative embodiments of the invention.

### DETAILED DESCRIPTION

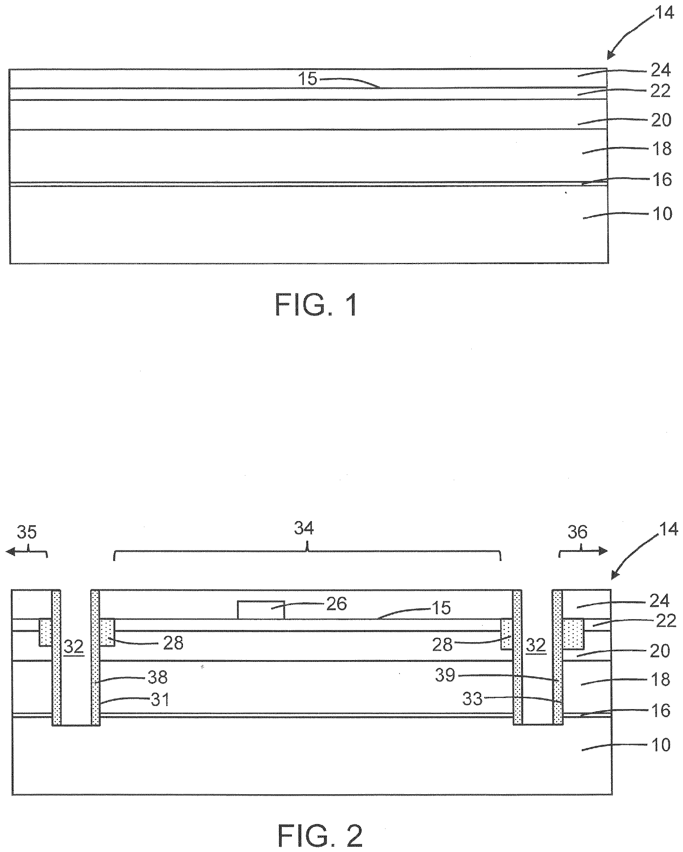

With reference to FIG. 1 and in accordance with embodiments of the invention, a layer stack 14 is formed on the top surface of a substrate 10. The substrate 10 may be comprised of a single-crystal semiconductor material, such as single-crystal silicon. The substrate 10 may be a bulk substrate that contains a single-crystal semiconductor material (e.g., single-crystal silicon). In an embodiment, the single-crystal semiconductor material of the substrate 10 may have a diamond crystal lattice structure with a <111> crystal orientation as specified by Miller indices. In an embodiment, the substrate 10 may contain single-crystal silicon with a diamond crystal lattice structure having a <111> crystal orientation. For a substrate 10 having a <111> crystal orientation, the (111) crystallographic plane is parallel to the top surface of the substrate 10, and the [111] crystallographic direction is normal to the (111) plane. In an embodiment, the substrate 10 may be fully comprised of semiconductor material with a <111> crystal orientation. The substrate 10 may be doped to have, for example, p-type conductivity. The substrate 10 may be heavily doped with a p-type dopant, such as boron, such that the resistivity is less than 100 ohm-cm. In alternative embodiments, the substrate 10 may be a different type of substrate, such as a sapphire substrate, an engineered substrate, etc. In alternative embodiments, the substrate 10 may be a silicon-on-insulator substrate.

The layer stack 14 may include a seed layer 16, a buffer layer 18, a channel layer 20, and a donor layer 22 each containing one or more compound semiconductor materials. The seed layer 16 provides a thin nucleation layer for the growth of the buffer layer 18 and may be comprised of, for example, aluminum nitride. The layers 16, 18, 20, 22 may be serially deposited using an epitaxial growth process, such as metalorganic chemical vapor deposition, vapor phase epitaxy, or molecular beam epitaxy, to form the layer stack 14. The layer stack 14 may have a thickness, for example, on the order of five microns.

The layers 16, 18, 20, 22 of the layer stack 14 may each have a crystal structure that is single crystal or, alternatively, a crystal structure that is substantially single crystal with varying levels of crystalline defectivity present. The buffer layer 18 may be comprised of one or more binary or ternary III-V compound semiconductor materials, such as gallium nitride, aluminum nitride, aluminum gallium nitride, or a combination of these materials, and is tailored in terms of material composition, doping, layering, and/or layer thickness to accommodate lattice mismatch, thermal property differences, and mechanical property differences between the material of the substrate 10 and the material of the channel layer 20. The channel layer 20, which is disposed over the buffer layer 18, may contain, for example, gallium nitride doped with carbon or iron. The donor layer 22, which is disposed over the channel layer 20, may contain a ternary III-V compound semiconductor, such as aluminum gallium nitride, that provides an heterogenous interface with the buffer layer 18 of different composition. The channel layer 20 may include a layer comprised of undoped gallium nitride adjacent to the donor layer 22, and an optional barrier layer comprised of, for example, aluminum nitride may be located between the channel layer 20 and the donor layer 22.

A gate layer 24 containing one or more III-V compound semiconductor materials may be formed on the donor layer 22 at the top surface 15 of the layer stack 14. The gate layer 24, which may be comprised of, for example, p-type gallium nitride, may be present on the layer stack 14 if constructing an enhancement-mode device that is normally off.

With reference to FIG. 2 in which like reference numerals refer to like features in FIG. 1 and at a subsequent fabrication stage, the gate layer 24 may be patterned by lithography and etching processes to define a gate 26 of an exemplary compound-semiconductor-based device that is positioned on the top surface 15 of the layer stack 14. A gate electrode comprised of, for example, titanium nitride may be positioned on a top surface of the gate 26.

An isolation region 28 may be formed adjacent to the top surface 15 of the layer stack 14 by, for example, a masked implantation of, for example, nitrogen. For example, the isolation region 28 may be located in the donor layer 22 and channel layer 20. A dielectric layer 30 is formed over the top surface 15 of the layer stack 14. The dielectric layer 30 may be comprised of a dielectric material (e.g., silicon dioxide) that is an electrical insulator, or a stack of dielectric materials (e.g., silicon dioxide and/or aluminum oxide). The dielectric layer 30 may be deposited and then planarized by chemical-mechanical polishing to eliminate topography. The gate 26 is embedded in the dielectric layer 30.

A trench 32 is patterned by lithography and etching processes. The trench 32 has sidewalls 31, 33 that extend fully through the dielectric layer 30 and the layer stack 14, and the trench 32 may penetrate to a shallow depth into the substrate 10. As a result, the trench 32 includes an upper portion in the dielectric layer 30, a middle portion in the layer stack 14, and a lower portion in the substrate 10. In an embodiment, the trench 32 may penetrate through the isolation region 28 to a trench bottom at which the sidewalls 31, 33 terminate.

Spacers 38, 39 are formed inside the trench 32. The spacers 38 may be formed by depositing a conformal layer of a dielectric material, such as silicon dioxide, and performing an anisotropic etching process. The dielectric material is removed by the anisotropic etching process from the trench bottom to expose the surface of the substrate 10. The spacer 38 coats the sidewall 31 of the trench 32 and the spacer 38 coats the sidewall 33 of the trench 32 such that the layer stack 14 bordering the opposite sidewalls 31, 33 of the trench 32 is coated by a liner of dielectric material. The spacers 38, 39 also coat the portions of the sidewalls 31, 33 of the trench 32 surrounded by the dielectric material of the dielectric layer 30.

The isolation region 28, the trench 32, and the spacers 38, 39 are arranged in the layer stack 14 to separate a portion of the layer stack 14 defining a device region 34 from adjacent portions of the layer stack 14 defining adjacent device regions 35, 36. In an embodiment, the isolation region 28, the trench 32, and the spacers 38, 39 may fully surround the device region 34. In an embodiment, the isolation region 28, the trench 32, and the spacers 38, 39 may be positioned in a lateral direction between the device region 34 and the device region 35 as a partition without surrounding the device region 34. In an embodiment, the isolation region 28, the trench 32, and the spacers 38, 39 may be positioned in a lateral direction between the device region 34 and the device region 36 as a partition without surrounding the device region 34.

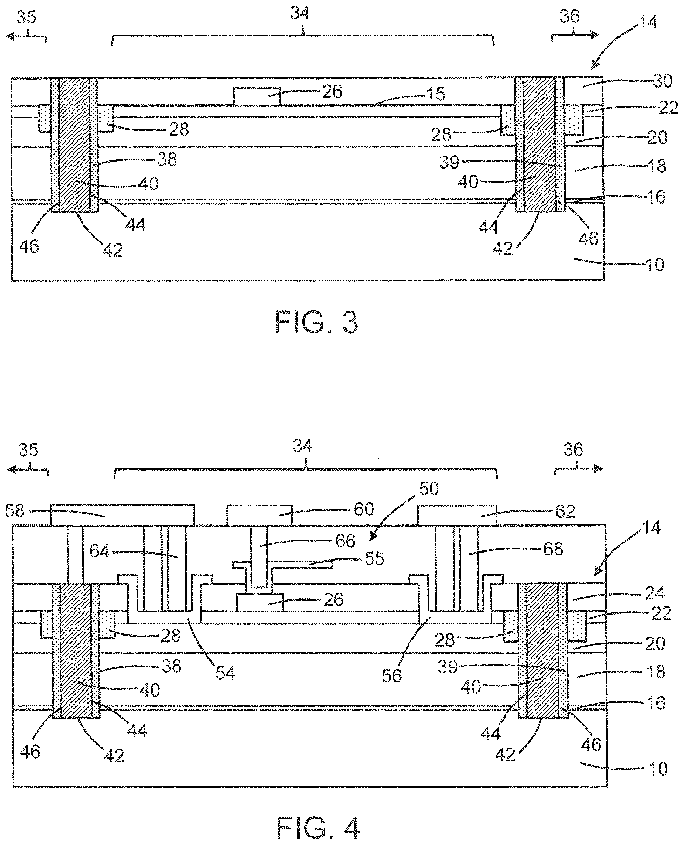

With reference to FIG. 3 in which like reference numerals refer to like features in FIG. 2 and at a subsequent fabrication stage, a conductive contact 40 is formed inside the trench 32 by deposition of a conductor and subsequent planarization. The conductive contact 40 includes an upper portion in the dielectric layer 30, a middle portion in the layer stack 14, and a lower portion in the substrate 10. The spacers 38, 39 are positioned inside the trench 32 between the layer stack 14 and the conductive contact 40, as well as between the dielectric layer 30 and the conductive contact 40. In an embodiment, the conductive contact 40 may be comprised of doped polysilicon. In an embodiment, the conductive contact 40 may be comprised of a metal, such as tungsten. The lower portion of the conductive contact 40 has an end 42 that is in direct contact with the substrate 10 at the trench bottom. The conductive contact 40 has an inner sidewall 44 and an outer sidewall 46 that each extend to the trench bottom, the inner sidewall 44 may be in direct contact with the spacer 38, and the outer sidewall 46 may be in direct contact with the spacer 39.

The conductive contact 40 is arranged in the layer stack 14 to separate the portion of the layer stack 14 defining the device region 34 from the adjacent portions of the layer stack 14 defining the adjacent device regions 35, 36. In an embodiment, the conductive contact 40 may fully surround the device region 34. In an embodiment, the conductive contact 40 may be positioned in a lateral direction between the device region 34 and the device region 35 as a partition without surrounding the device region 34. In an embodiment, the conductive contact 40 may be positioned in a lateral direction between the device region 34 and the device region 36 as a partition without surrounding the device region 34. In an embodiment, the conductive contact 40 may be a solid piece of conductor that lacks a core filled by dielectric material. In an embodiment, the conductor deposited to form conductive contact 40 may be non-conformal such that the space inside the trench 32 is fully filled by conductor.

In an alternative embodiment, the conductive contact 40 may include one or more sections that surround a perimeter of a die that includes multiple device regions. In an alternative embodiment, the conductive contact 40 may include one or more sections that are positioned adjacent to scribe lines, thereby eliminating the need for laser grooving that could otherwise generate cracks that could propagate to the device regions of the die. In an alternative embodiment, the conductive contact 40 may include one or more sections that are positioned within scribe lines of the die.

With reference to FIG. 4 in which like reference numerals refer to like features in FIG. 3 and at a subsequent fabrication stage, a high-electron-mobility transistor, which is generally indicated by reference numeral 50, may be formed in the device region 34, after the formation of the conductive contact 40, as an exemplary compound-semiconductor-based device. The high-electron-mobility transistor 50 may include a source ohmic contact 54 and a drain ohmic contact 56 that are formed on different portions of the layer stack 14. The source ohmic contact 54 and drain ohmic contact 56 may be formed in recesses penetrating through the donor layer 22 to the channel layer 20. The source ohmic contact 54 and the drain ohmic contact 56 are in a contacting relationship with at least one of the layers 16, 18, 20, 22 of the layer stack 14 in the device region 34. In an embodiment, the source ohmic contact 54 and drain ohmic contact 56 may comprise an ohmic metal, such as titanium, titanium nitride, aluminum, silicon, or a combination of these materials. The gate 26 is positioned in a lateral direction between the source ohmic contact 54 and the drain ohmic contact 56, and gate metal 55 may be disposed on top of the gate 26. The gate metal 55 may include a field plate that extends in a lateral direction toward the drain ohmic contact 56. The high-electron-mobility transistor 50 also includes the portions of the channel layer 20 and donor layer 22 in the device region 34 of the layer stack 14 in which the two-dimensional electron gas (2DEG) is formed during operation.

Middle-of-line processing and back-end-of-line processing follow, which includes formation of contacts, vias, and wiring for an interconnect structure positioned over the substrate 10 and connected to the conductive contact 40 and the high-electron-mobility transistor 50. An interconnect 58 is coupled by contacts 64 to the conductive contact 40 and the source ohmic contact 54 of the high-electron-mobility transistor 50. An interconnect 60 is coupled by contacts 66 to the gate metal 55 of the high-electron-mobility transistor 50. An interconnect 62 is coupled by contacts 68 to the drain ohmic contact 56 of the high-electron-mobility transistor 50. The interconnects 58, 60, 62 may be comprised of a patterned metal, such as copper or aluminum. The contacts 64, 66, 68 may be formed in a dielectric layer 70, and may be comprised of a metal, such as tungsten, formed in contact openings patterned in the dielectric layer 70.

The conductive contact 40 may be effective to reduce the risk of post-growth cracking and/or breakage due to differences in the coefficient of thermal expansion between the layer stack 14 and substrate 10, as well as stresses from other sources. The conductive contact 40 may be effective to minimize post-growth changes in the mechanical shape, such as bowing and warpage, of the substrate 10 and layer stack 14.

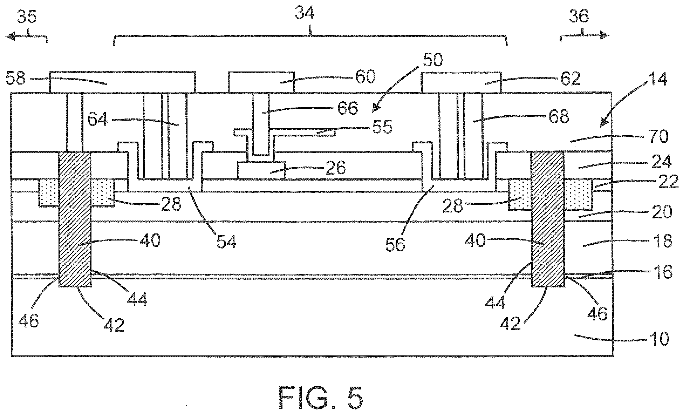

With reference to FIG. 5 and in accordance with alternative embodiments, the spacers 38, 39 may be omitted and not formed to line the trench 32 before the formation of the conductive contact 40. As a result, the inner sidewall 44 and the outer sidewall 46 of the conductive contact 40 may be in direct contact with the layer stack 14 at the sidewalls 31, 33 of the trench 32. The inner sidewall 44 and the outer sidewall 46 of the conductive contact 40 may also be in direct contact with the isolation region 28 adjacent to the top surface 15 of the layer stack 14 and with the dielectric layer 30 above the top surface 15 of the layer stack 14.

The methods as described above are used in the fabrication of integrated circuit chips. The resulting integrated circuit chips can be distributed by the fabricator in raw wafer form (e.g., as a single wafer that has multiple unpackaged chips), as a bare die, or in a packaged form. In the latter case, the chip is mounted in a single chip package (e.g., a plastic carrier, with leads that are affixed to a motherboard or other higher level carrier) or in a multichip package (e.g., a ceramic carrier that has either or both surface interconnections or buried interconnections). In any case, the chip may be integrated with other chips, discrete circuit elements, and/or other signal processing devices as part of either an intermediate product or an end product.

References herein to terms modified by language of approximation, such as "about", "approximately", and "substantially", are not to be limited to the precise value specified. The language of approximation may correspond to the precision of an instrument used to measure the value and, unless otherwise dependent on the precision of the instrument, may indicate +/- 10% of the stated value(s).

References herein to terms such as "vertical", "horizontal", etc. are made by way of example, and not by way of limitation, to establish a frame of reference. The term "horizontal" as used herein is defined as a plane parallel to a conventional plane of a semiconductor substrate, regardless of its actual three-dimensional spatial orientation. The terms "vertical" and "normal" refer to a direction perpendicular to the horizontal, as just defined. The term "lateral" refers to a direction within the horizontal plane.

A feature "connected" or "coupled" to or with another feature may be directly connected or coupled to or with the other feature or, instead, one or more intervening features may be present. A feature may be "directly connected" or "directly coupled" to or with another feature if intervening features are absent. A feature may be "indirectly connected" or "indirectly coupled" to or with another feature if at least one intervening feature is present. A feature "on" or "contacting" another feature may be directly on or in direct contact with the other feature or, instead, one or more intervening features may be present. A feature may be "directly on" or in "direct contact" with another feature if intervening features are absent. A feature may be "indirectly on" or in "indirect contact" with another feature if at least one intervening feature is present.

The descriptions of the various embodiments of the present invention have been presented for purposes of illustration but are not intended to be exhaustive or limited to the embodiments disclosed. Many modifications and variations will be apparent to those of ordinary skill in the art without departing from the scope and spirit of the described embodiments. The terminology used herein was chosen to best explain the principles of the embodiments, the practical application or technical improvement over technologies found in the marketplace, or to enable others of ordinary skill in the art to understand the embodiments disclosed herein.

## Claims

1. A structure comprising:
a substrate;
a layer stack on the substrate, the layer stack including a plurality of semiconductor layers each comprising a compound semiconductor material;
a conductive contact extending in a vertical direction fully through the layer stack to the substrate, the conductive contact arranged in the layer stack to separate a first portion of the layer stack from a second portion of the layer stack; and
a device structure including a source ohmic contact and a drain ohmic contact, the source ohmic contact and the drain ohmic contact in a contacting relationship with at least one of the plurality of semiconductor layers of the first portion of the layer stack.

2. The structure of claim 1 wherein the conductive contact fully surrounds the first portion of the layer stack.

3. The structure of claim 1 wherein the conductive contact is positioned in a lateral direction between the first portion of the layer stack and the second portion of the layer stack as a partition.

4. The structure of one of claims 1 to 3 wherein the device structure is a high-electron-mobility transistor that includes a gate on the first portion of the layer stack.

5. The structure of one of claims 1 to 4 wherein the substrate comprises a heavily-doped semiconductor material.

6. The structure of one of claims 1 to 5 wherein the compound semiconductor material of at least one of the plurality of semiconductor layers comprises gallium nitride.

7. The structure of one of claims 1 to 6 further comprising:
a dielectric layer on the layer stack,
wherein the conductive contact includes a first portion in the layer stack and a second portion in the dielectric layer, and, optionally, wherein the conductive contact is formed in a trench penetrating through the dielectric layer and the layer stack to the substrate, the trench has an inner sidewall and an outer sidewall, and further comprising:
a first dielectric spacer between the conductive contact and the inner sidewall of the trench; and
a second dielectric spacer between the conductive contact and the outer sidewall of the trench.

8. The structure of one of claims 1 to 7 wherein the conductive contact has an end in direct contact with the substrate.

9. The structure of one of claims 1 to 8 wherein the conductive contact comprises tungsten or doped polysilicon.

10. The structure of one of claims 1 to 6, 8 and 9 wherein the conductive contact is formed in a trench penetrating through the layer stack to the substrate, the trench has an inner sidewall and an outer sidewall, and further comprising:
a first dielectric spacer between the conductive contact and the inner sidewall of the trench; and
a second dielectric spacer between the conductive contact and the outer sidewall of the trench.

11. The structure of claim 10 wherein the conductive contact, the first dielectric spacer, and the second dielectric spacer fully surround the first portion of the layer stack, or wherein the conductive contact, the first dielectric spacer, and the second dielectric spacer are positioned in a lateral direction between the first portion of the layer stack and the second portion of the layer stack as a partition.

12. The structure of one of claims 1 to 11 further comprising:
an isolation region in one or more of the plurality of semiconductor layers of the layer stack,
wherein the conductive contact penetrates through the isolation region;
and, optionally, wherein the conductive contact and the isolation region fully surround the first portion of the layer stack, or the conductive contact and the isolation region are positioned in a lateral direction between the first portion of the layer stack and the second portion of the layer stack as a partition.

13. A method comprising:
forming a layer stack on a substrate, wherein the layer stack includes a plurality of semiconductor layers each comprising a compound semiconductor material; and
forming a conductive contact extending in a vertical direction fully through the layer stack to the substrate, wherein the conductive contact is arranged in the layer stack to separate a first portion of the layer stack from a second portion of the layer stack; and
forming a device structure including a source ohmic contact and a drain ohmic contact, wherein the source ohmic contact and the drain ohmic contact in a contacting relationship with at least one of the plurality of semiconductor layers of the first portion of the layer stack.

14. The method of claim 13 wherein the conductive contact is formed in a trench penetrating through the layer stack to the substrate, the trench has an inner sidewall and an outer sidewall, and further comprising:
forming a first dielectric spacer between the conductive contact and the inner sidewall of the trench; and
forming a second dielectric spacer between the conductive contact and the outer sidewall of the trench.

15. The method of claim 13 or claim 14 wherein the conductive contact is formed in a trench penetrating through the layer stack to the substrate, and the trench is formed before the device structure is formed.
